# EUROPÄISCHE PATENTSCHRIFT

(11) **EP 1 442 503 B1**
(45) Veröffentlichungstag und Bekanntmachung des Hinweises auf die Patenterteilung: **03.05.2006**
(21) Anmeldenummer: 02779521.0
(22) Anmeldetag: 31.10.2002
(51) Int. Cl.: H01R 9/24

(54) **ANORDNUNG BESTEHEND AUS EINEM PANEELARTIG AUFGEBAUTEN MODUL UND AUS EINER ANSCHLUSSEINHEIT, HERSTELLUNGSVERFAHREN UND VORRICHTUNG**
ASSEMBLY COMPRISED OF A PANEL-LIKE CONSTRUCTED MODULE AND OF A CONNECTION UNIT, PRODUCTION METHOD AND DEVICE
SYSTEME COMPRENANT UN MODULE DE TYPE PANNEAU ET UNE UNITE DE RACCORDEMENT, PROCEDE DE PRODUCTION ET UTILISATION CORRESPONDANTS

(30) Priorität: 07.11.2001 DE 10154234
(43) Veröffentlichungstag der Anmeldung: 04.08.2004
(73) Patentinhaber: Leopold Kostal GmbH & Co. KG, 58507 Lüdenscheid (DE); SOLARWORLD AKTIENGESELLSCHAFT, 53113 Bonn (DE)
(72) Erfinder: BERGMANN, Eduard, 58515 Lüdenscheid (DE); RILLING, Herwig, 59174 Kamen (DE); WESTERMAYR, Peter, 53229 Bonn (DE); HOFBAUER, Clemens, 93158 Teublitz (DE); KLEBENSBERGER, Boris, 76307 Karlsbad (DE); WAMBACH, Karsten, 09603 Bräunsdorf (DE)
(74) Vertreter: Haverkamp, Jens
(86) Internationale Anmeldenummer: PCT/EP2002/012158
(87) Internationale Veröffentlichungsnummer: WO 2003/041227

(56) Entgegenhaltungen:
- US-A- 2 869 040
- US-A- 5 434 749
- US-A- 5 478 244

## Beschreibung

Die Erfindung betrifft eine Anordnung umfassend ein paneelartig aufgebautes elektrisches/elektronisches Modul mit einer flachen Oberfläche mit freiliegend kontaktierbaren Anschlußabschnitten als Teil einer im wesentlichen ebenen Leiterbahnstruktur zum elektrischen Anschließen des Moduls sowie umfassend eine Anschlußeinheit mit auf einer in einer Ebene parallel zur Leiterbahnstruktur des Moduls angeordneten Leiterbahnstruktur befindlichen elektrischen/elektronischen Elementen sowie ausgestattet mit Mitteln zum Kontaktieren von Anschlußabschnitten des Moduls, so daß das Modul über die Anschlußeinheit elektrisch anschließbar ist. Ferner betrifft die Erfindung eine Anschlußeinheit für eine solche Anordnung sowie ein Verfahren zum Erstellen einer solchen Anordnung. Die Erfindung betrifft auch ein Verfahren zum Verbinden einer Anschlußeinheit mit einem paneelartig aufgebauten Modul zum Erstellen einer solchen Anordnung sowie eine Vorrichtung zum Verbinden einer Anschlußeinheit mit einem paneelartig aufgebauten Modul zum Herstellen einer solchen Anordnung.

Paneelartig aufgebaute elektrische/elektronische Komponenten sind beispielsweise als Solarstrommodule bzw. Solarstrompaneele ausgebildet. Ein solches Solarstrommodul besteht aus mehreren einzelnen Solarzellenanordnungen, die hinter einer transparenten Schutzschicht, beispielsweise einer Glasscheibe mit ihrer photosensitiven Oberfläche zur Glasscheibe weisend angeordnet sind. Rückseitig sind diese Solarzellen untereinander durch Leiterbahnstrukturen miteinander elektrisch verbunden. Die zur elektrischen Verbindung der einzelnen Solarzellen eines solchen Solarstrommoduls eingesetzte Leiterbahnstruktur dient ebenfalls zum Anschließen des Solarstrommoduls an weitere Solarstrommodule bzw. an ein Netz. Zu diesem Zweck sind verbunden mit entsprechenden Anschlußabschnitten des Stanzgitters frei kontaktierbare Steckbuchsen aufgenommen in einem Steckbuchsengehäuse, so daß diese durch ein komplementär ausgebildetes Steckverbindungsteil kontaktiert werden können. Das Steckbuchsengehäuse mit den einzelnen frei kontaktierbaren als Anschlußabschnitte des Stanzgitters vorgesehenen Steckbuchsen ist integriert in die rückseitige Abdeckung der Solarzellenanordnung. Teil einer solchen Anordnung ist ferner eine Anschlußeinheit, die als Mittel zum Kontaktieren der Kontaktbuchsen einen Stecker umfaßt. Der Stecker selber ist mit seinen männlichen Steckerteilen elektrisch angeschlossen an eine auf einer Leiterplatte aufgebrachte Leiterbahnstruktur. Die nach herkömmlicher Art und Weise ausgebildete Leiterbahnstruktur dient zum Anordnen von Schutzdioden, die notwendig sind, damit bei einer Teilbeschattung des Solarstrommoduls eine Zerstörung einzelner Solarzellen verhindert wird. Solarstrommodule müssen wind- und wetterfest sein und dies über eine Zeitspanne von mindestens 25 Jahren. Daher ist es wesentlich, daß die elektrischen Übergänge gegenüber einem Eindringen von Feuchtigkeit über die gesamte Lebensdauer geschützt sind. Die Anschlußeinheit ist daher zum Schutze der Steckverbindung eingesetzt in ein Gehäuse, das seinerseits abgedichtet auf der rückseitigen Abdeckung des Solarstrommoduls aufgeklebt ist. Auf der Rückseite eines solchen Solarstrommoduls entstehen hohe Temperaturen, so daß die Anschlußeinheit und insbesondere auch die zum Anschließen des Solarstrommoduls vorgesehenen Mittel der Anschlußeinheit entsprechend temperaturbeständig sein müssen. Ferner ist sicher zu stellen, daß die eingesetzten elektrischen/elektronischen Komponenten der Anschlußeinheit, beispielsweise die Schutzdioden, bei einem Betrieb des Solarstrommoduls nicht so weit aufgeheizt werden, daß diese dadurch zerstört werden. Dieses ist bei den vorbekannten Anordnungen jedoch nicht immer zu gewährleisten.

Eine elektrische Verbindung zwischen der Leiterbahnstruktur der Anschlußeinheit und derjenigen des Moduls ist durch den Einsatz der Steckverbindungsteile relativ aufwendig. Zudem muß das der Anschlußeinheit zugehörige Steckverbindungsteil manuell in Eingriff gestellt werden mit den Steckbuchsen des Moduls. Auch wenn grundsätzlich ein solches Ineingriffstellen von zwei Steckverbindungsteilen maschinell möglich ist, wird zur Ausbildung der Steckverbindungsteile eine gewisse Bauhöhe benötigt. Insbesondere bei paneelartig aufgebauten elektrisehen/elektronischen Modulen, wie beispielsweise bei Solarstrommodulen ist jedoch ein möglichst flacher Aufbau erwünscht.

Ausgehend von diesem diskutierten Stand der Technik liegt der Erfindung daher die Aufgabe zugrunde, eine eingangs genannte Anordnung dergestalt weiter zu bilden, daß insbesondere das Erstellen einer elektrischen Verbindung zwischen der Anschlußeinheit und dem Modul nicht nur mit einfacheren Mitteln sondern auch maschinell durchführbar ist. Der Erfindung liegt ferner die Aufgabe zugrunde, eine Anschlußeinheit für eine solche Anordnung bereitzustellen, die grundsätzlich maschinell mit einem solchen Modul verbindbar ist und bei der die Problematik einer zu starken Erwärmung der elektrischen/elektronischen Komponenten vermieden ist, sowie ein Verfahren und eine Vorrichtung zum Erstellen bzw. Herstellen einer maschinellen elektrischen Verbindung zwischen einer Anschlußeinheit und einem Modul vorzuschlagen.

Die anordnungsbezogene Aufgabe wird erfindungsgemäß dadurch gelöst, daß die Mittel zum Kontaktieren der Anschlußabschnitte des Moduls aus der Ebene der Leiterbahnstruktur herausgebogene und einen Teil der Leiterbahnstruktur darstellende Anschlußabschnitte und die Anschlußabschnitte des Moduls starre und aus der Ebene der Leiterbahnstruktur des Moduls herausbiegbare elektrische Leiterabschnitte sind, wobei die Anschlußabschnitte der Anschlußeinheit entsprechend der Anordnung der Anschlußabschnitte des Moduls angeordnet sind, so daß bei der mit dem Modul verbundenen Anschlußeinheit jeweils ein Anschlußabschnitt des Moduls und einer der Anschlußeinheit elektrisch miteinander verbunden in einem Abschnitt aneinandergrenzen und im Bereich des Aneinandergrenzens in einer anderen Raumlage als diejenige der Ebenen der Leiterbahnstrukturen angeordnet sind.

Die beanspruchte Anschlußeinheit für eine solche Anordnung ist gekennzeichnet dadurch, daß die Leiterbahnstruktur der Anschlußeinheit ein Stanzgitter ist und die zum Kontaktieren der Anschlußabschnitte des Moduls vorgesehenen Anschlußabschnitte der Leiterbahnstruktur der Anschlußeinheit Teil des Stanzgitters sind, auf welchem Stanzgitter die elektrischen/elektronischen Komponenten, etwa Dioden, und zumindest ein Anschlußkabel durch eine Fügeverbindung mit dem Stanzgitter verbunden angeordnet sind.

Die verfahrensbezogene Aufgabe wird durch die Merkmale des Anspruchs 13 gelöst. Die vorrichtungsbezogene Aufgabe wird durch die Merkmale des Anspruchs 18 gelöst.

Beim Gegenstand der beanspruchten Anordnung sind die Anschlußabschnitte des Moduls als starre, jedoch biegbare Leiterbahnstrukturabschnitte konzipiert. Damit ist es möglich, daß zum Erstellen einer elektrischen Verbindung zwischen einem Anschlußabschnitt des Moduls und einem solchen der Anschlußeinheit die Anschlußabschnitte des Moduls, die zunächst flach auf der Rückseite des Moduls aufliegen, durch einen Anhebeschritt von der Oberfläche abgehoben werden können, wobei diese dann von der Oberfläche des Moduls abgehoben verbleiben. Auf diese Weise ist es maschinell möglich, die ansonsten verdeckte untere Rückseite der Anschlußabschnitte des Moduls zugänglich zu machen, insbesondere zum Erstellen einer Fügeverbindung mit einem Anschlußabschnitt der Anschlußeinheit. Dabei kann vorgesehen sein, daß die Anschlußabschnitte der Anschlußeinheit aus der Ebene der Leiterbahnstruktur der Anschlußeinheit herausgebogen sind und somit für die Anschlußabschnitte des Moduls ein Biegewiderlager darstellen können. Gleichfalls ist es möglich, die Anschlußabschnitte von Anschlußeinheit und Modul in parallelen Ebenen zueinander anzuordnen, damit diese anschließend gemeinsam aus ihrer ursprünglichen Ebene herausgebogen werden können. In jedem Fall befindet sich eine aus jeweils einem Anschlußabschnitt des Moduls und einem solchen der Anschlußeinheit gebildete Verbindungseinheit in einer anderen Raumlage als die jeweiligen Leiterbahnabschnitte, so daß grundsätzlich beide gegenüber liegenden Außenseiten einer solchen Verbindungseinheit frei zugänglich sind. Diese andere Raumlage einer solchen Verbindungseinheit kann beispielsweise eine etwa rechtwinklige Abwinklung darstellen. Vorgesehen sein kann auch eine Verdrehung um eine in der Ebene der angrenzenden Leiterbahnstrukturen befindliche Achse.

Die Leiterbahnstruktur der gesondert beanspruchten Anschlußeinheit ist gebildet durch ein Stanzgitter, wobei die zum Anschluß der Anschlußeinrichtung an das Modul vorgesehenen Anschlußabschnitte Teil des Stanzgitters sind. Auf dem Stanzgitter sind ebenfalls die benötigten elektrischen/elektronischen Komponenten angeordnet. Der Vorteil beim Einsatz eines Stanzgitters ist zum einen, daß die elektrischen/elektronischen Komponenten mit diesem durch eine Schweißverbindung verbunden werden können und insbesondere, daß über das Stanzgitter eine sehr viel gleichmäßigere Wärmeabfuhr gegeben ist, als dies bei Einsatz einer auf einer Leiterplatte befindlichen Leiterbahnstruktur gegeben wäre. Folglich dient das Stanzgitter nicht nur zum Darstellen der benötigten Leiterbahnstruktur, sondern auch als Kühlelement.

Der Einsatz von Anschlußabschnitten als Teil des die Leiterbahnstruktur bildenden Stanzgitters macht zudem einen Einsatz von zusätzlichen Mitteln zum Anschließen der Anschlußeinrichtung an das Modul grundsätzlich überflüssig. Daher ist es möglich, das mit den elektrischen/elektronischen Komponenten, beispielsweise den Schutzdioden und zumindest einem elektrischen Anschlußkabel bestückte Stanzgitter durch ein Vergußmaterial zu verkapseln, wobei die zum Anschluß der Anschlußeinrichtung vorgesehenen Anschlußabschnitte aus dem gebildeten Vergußkörper, etwa durch ein Spritzgußverfahren hergestellt, herausragen. Diese können beispielsweise hineinragen in ein in dem Vergußkörper vorgesehenes Fenster. Somit ist auf einfache Weise die gesamte Anschlußeinrichtung verkapselbar. Insbesondere bei Vorsehen eines Fensters, in welches die zum Anschluß der Anschlußeinrichtung vorgesehenen Anschlußabschnitte hineinragen, kann dieses Fenster in einem zweiten Schritt ebenfalls auf einfache Weise wirksam gegen eindringende Feuchtigkeit verfüllt, beispielsweise vergossen werden. Das zusätzliche Vorsehen eines eigenen am Modul zu befestigenden Gehäuses ist daher grundsätzlich nicht notwendig.

Die äußere Oberfläche des das Stanzgitter der Anschlußeinrichtung verkapselnden Vergußkörper kann strukturiert sein durch oberflächenvergrößernde Elemente, beispielsweise Kühlkörper, Kühlrippen und dergleichen.

Eine Anschlußeinrichtung wie oben beschrieben kann ohne weiteres unmittelbar auf der Rückseite des Moduls befestigt werden. Nachfolgend ist die Erfindung anhand eines Ausführungsbeispieles unter Bezugnahme auf die beigefügten Figuren beschrieben. Es zeigen:
- **Fig. 1**: eine schematisierte perspektivische Ansicht der Leiterbahnstruktur einer Anschlußeinrichtung für ein Solarstrommodul,
- **Fig. 2**: den in Figur 1 dargestellten Teil der Anschlußeinrichtung gekapselt in einem Vergußkörper mit an der Anschlußeinrichtung angeschlossenen Anschlußabschnitten der Leiterbahnstruktur des Solarstrommoduls und
- **Fig. 3**: einen Schnitt durch die Anordnung der Figur 2 entlang der Linie A - B.

Eine Anschlußeinheit 1 ist vorgesehen zum Anschließen eines Solarstrommoduls. Die Anschlußeinheit 1 umfaßt ein insgesamt mit dem Bezugszeichen 2 bezeichnetes Stanzgitter, durch welches die Leiterbahnstruktur der Anschlußeinheit 1 gebildet ist. Das Stanzgitter 2 ist bezüglich seiner einzelnen Abschnitte zunächst durch Brücken B miteinander verbunden. Die Brücken B werden nach einer Bestückung des Stanzgitters 2 entfernt. Die Brücken B dienen lediglich einer Stabilisierung des Stanzgitters 2, bis das dieses in einen Vergußkörper im Wege eines Spritzgußverfahrens gekapselt wird.

Das als Leiterbahnstruktur dienende Stanzgitter 2 dient zum Anordnen von Schutzdioden D, um bei einer Teilbeschattung des Solarstrommoduls eine Zerstörung einzelner Solarzellen zu verhindern. In dem dargestellten Ausführungsbeispiel sind jeweils zwei Schutzdioden D paarweise angeordnet. Durch Ausbildung der Leiterbahnstruktur als Stanzgitter 2 ist es möglich, die jeweiligen durch eine oder mehrere Dioden zu kontaktierenden Bereiche so groß vorzusehen, daß in Abhängigkeit von der gewünschten Ausgestaltung der Anschlußeinheit 1 ein oder mehrere Dioden an jeweils einer solchen Position angeordnet werden können. An das Stanzgitter 2 sind ferner zwei Anschlußkabel 3, 4 angeschlossen. Sowohl die Anschlußkabel 3, 4 als auch die Dioden D sind mit dem Stanzgitter 2 durch eine Schweißung verbunden. Im Hinblick auf die gewünschte Lebensdauer und die Anfälligkeit einer solchen Verbindung ist eine Schweißverbindung wesentlich belastbarer als eine Lötverbindung oder eine Schraub-Klemmverbindung, wie dies beim vorbekannten Stand der Technik eingesetzt war.

Das als Leiterbahnstruktur ausgebildete Stanzgitter 2 umfaßt mehrere Anschlußabschnitte A_{A}, mit denen der Anschlußabschnitt des Solarstrommoduls kontaktiert werden sollen. Diese Anschlußabschnitte A_{A} sind aus dem Material des Stanzgitters 2 und aus der Ebene des Stanzgitters 2 herausgebogen, um eine elektrische Verbindung mit Anschlußabschnitten des Solarstrommoduls - wie weiter unten beschrieben - herstellen zu können. In dem dargestellten Ausführungsbeispiel sind die Anschlußabschnitte A_{A} etwa rechtwinklig aus der Ebene des Stanzgitters 2 herausgebogen.

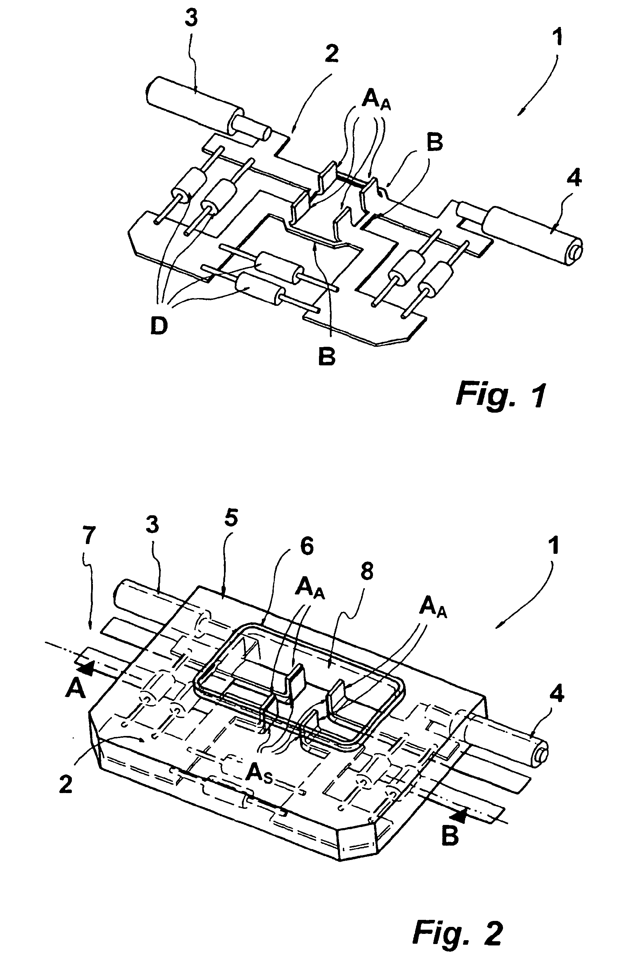

Das Stanzgitter 2 ist mit den als elektrische/elektronische Komponenten dienenden Dioden D und den am Stanzgitter 2 befestigten Enden der Anschlußkabel 3, 4 zur Kapselung vergossen und befindet sich, wie in Figur 2 dargestellt, in einem Vergußkörper 5. Der Vergußkörper 5 ist in Figur 2 schematisiert dargestellt. Der Vergußkörper kann ebenfalls eine strukturierte Oberfläche zur Oberflächenvergrößerung aufweisen, etwa durch Nachempfinden allein der durch die Dioden hervorgerufenen Erhöhungen. Ferner kann der Vergußkörper oberflächenvergrößernde Elemente, etwa Kühlrippen, tragen, um eine bessere Kühlung der Anschlußeinheit 1 er zielen zu können.

Figur 2 zeigt die Anschlußeinheit 1 bereits in elektrischer Verbindung seiner Anschlußabschnitte A_{A} mit den Anschlußabschnitten A_{S} eines Solarstrommoduls 7, welches der Übersicht halber bis auf seine Anschlußabschnitt A_{S} nicht näher dargestellt ist.

Der Vergußkörper 5 ist möglichst flach gehalten und weist zum Schutze der Anschlußabschnitte A_{A} einen Vergußkragen 6 auf, der ein Fenster 8, in das die Anschlußabschnitte A_{A} der Anschlußeinheit 1 des Vergußkörpers 5 hineinragen, einschließt. Die Anordnung der Anschlußabschnitte A_{A} der Anschlußeinheit 1 und der Anschlußabschnitt A_{S} des Solarstrommoduls 7 sind bei dem dargestellten Ausführungsbeispiel in zwei übereinander liegenden Ebenen angeordnet. Auch die Anschlußabschnitte A_{S} des Solarstrommoduls 7 sind Teil von Flachbandleitern, so daß diese starr, jedoch aus der Ebene des Solarstrommoduls herausbiegbar sind. In einer ersten Montagestellung liegen die Anschlußabschnitte A_{A} und A_{S} in unterschiedlichen Ebenen übereinander, wobei die Anschlußabschnitte A_{A}, wie in Figur 1 gezeigt, zur Ebene des Stanzgitters 2 der Anschlußeinheit 1 abgewinkelt sind. Zum Erstellen der gewünschten Schweißverbindung zwischen jeweils einem Anschlußabschnitt A_{A} und A_{S} werden bevorzugt maschinell die Anschlußabschnitte A_{S} des Solarstrommoduls 7 ergriffen, beispielsweise durch Sauggreifer oder Wirbelstromgreifer und angehoben. Zweckmäßigerweise wird zuvor ein Niederhalter auf die nicht aus der Ebene des Solarstrommoduls 7 anzuhebenden Abschnitte der Flachbandleiter positioniert. Der Niederhalter stellt dann auch ein Biegewiderlager dar, um den in einem nächsten Schritt die Anschlußabschnitte A_{S} des Solarstrommoduls 7 aus der Ebene des Solarstrommoduls 7 herausgebogen werden, bis diese an der freien Außenseite der Anschlußabschnitte A_{A} der Anschlußeinheit 1 anliegen, so daß auf diese Weise die Anschlußabschnitte A_{S} des Solarstrommoduls 7 mit den Anschlußabschnitten A_{A} der Anschluße9inheit 1 zusammengeführt sind. Zum Erstellen einer Fügeverbindung zwischen jeweils zwei Anschlußabschnitten A_{A} und A_{S} sind nunmehr die beiden gegenüberliegenden Außenseiten einer solchen aus jeweils einem Anschlußabschnitt A_{A} und A_{S} gebildeten Verbindungseinheit frei zugänglich. Die gewünschte Fügeverbindung, beispielsweise eine Schweißung, erfolgt bevorzugt maschinell, kann jedoch auch manuell durchgeführt werden. Grundsätzlich können sämtliche Montagevorgänge maschinell durchgeführt werden, so daß dann eine Bestückung eines Solarstrommoduls 7 mit einer Anschlußeinheit 1 insgesamt maschinell durchgeführt werden kann.

In einem nicht dargestellten Ausführungsbeispiel verbleiben die Anschlußabschnitte des Stanzgitters der Anschlußeinheit zunächst in der Ebene des Stanzgitters angeordnet und sind nicht wie in Figur 1 gezeigt bereits aus der Ebene herausgebogen. Ein Herausbiegen dieser Anschlußabschnitte erfolgt bei diesem Ausführungsbeispiel gemeinsam mit den Anschlußabschnitten des Solarstrommoduls, wobei auch bei diesem Ausführungsbeispiel zweckmäßigerweise ein Niederhalter als Biegewiderlager dient.

Vor dem Herausbiegen der Anschlußabschnitte A_{S} ist die Anschlußeinheit 1 auf der Rückseite des Solarstrommoduls 7 fixiert. Zur Fixierung der Anschlußeinheit 1 auf der Rückseite des Solarstrommoduls 7 ist es zweckmäßig, zunächst eine rasch haftend, etwa klebende Verbindung zwischen den beiden Elementen herzustellen, damit quasi unmittelbar nach Aufsetzen der Anschlußeinheit 1 auf die Rückseite des Solarstrommoduls die elektrische Verbindung zwischen den Anschlußabschnitten A_{A} und A_{S} jeweils hergestellt werden kann. Zu diesem Zweck weist die Unterseite der Anschlußeinheit 1 des dargestellten Ausführungsbeispiels einzelne Klebedome auf, um mit kleiner Auflagefläche eine solche rasche Fixierung mittels eines sogenannten Sekundenklebers realisieren zu können. Umfänglich ist zusätzlich die Anschlußeinheit 1 auf der Rückseite des Solarstrommoduls 7 mit einem langsamer aushärtenden Kleber oder einem Klebeband verbunden, der über die Lebensdauer der aus der Anschlußeinheit 1 und dem Solarstrommodul 7 gebildeten Anordnung höheren Belastungen standhält.

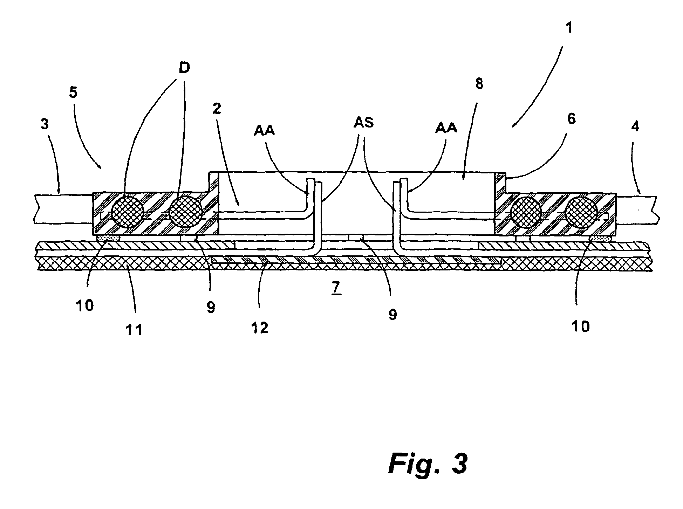

Die Anordnung der Anschlußeinheit 1 auf der Rückseite des Solarstrommoduls 7 ist in der Schnittdarstellung der Figur 3 erkennbar. Darin sind ebenfalls die beschriebenen Klebedome 9 und der Klebering 10 dargestellt.

Aus Figur 3 ist ebenfalls der rückseitige Aufbau des Solarstrommoduls 7 erkennbar, insbesondere die Anordnung der Anschlußleiter A_{S}. Die Flachbandleiter sind grundsätzlich mit den übrigen Teilen durch eine Klebeschicht 11 verbunden. Lediglich im Bereich der aufzubiegenden Anschlußabschnitte A_{S} der Flachbandleiter sind diese durch eine Trennfolie 12 von der Klebeschicht 11 getrennt, so daß die Anschlußabschnitte A_{S} ohne weiteres von der Trennfolie 12 abgehoben werden können. Bei dem dargestellten Ausführungsbeispiel dient als Trennschicht die Trennfolie 12. Anstelle dieser können auch andere Trennmittel eingesetzt werden, wie beispielsweise ein Trennpulver, ein Trennwachs oder dergleichen. Die Trennfolie 12 verbleibt als Teil des Solarstrommoduls 7. Die Trennfolie 12 genügt den Anforderungen an die Witterungs- und Temperaturbeständigkeit der Anordnung. Beispielsweise kann die Trennfolie eine UV-stabile Polyesterfolie sein. Die Trennfolie 12 weist zusätzlich Führungen auf, in die die Anschlußabschnitte A_{S} eingesetzt sind und diese somit bei ihrem Aufbiegen gewissermaßen seitlich geführt bzw. gehalten sind. Der Übersicht halber sind diese Führungen in Figur 3 nicht dargestellt.

Die Anschlußabschnitte der Anschlußeinheit können ebenfalls endseitig jeweils eine Verkröpfung aufweisen, so daß durch diese Verkröpfung der Höhenunterschied zwischen den beiden Ebenen der Stanzgitter überwunden wird.

Der Einsatz eines Stanzgitters 2 als Leiterbahnstruktur hat überdies den Vorteil, daß aufgrund des eingesetzten Materials und der Materialmenge eine sehr gute Wärmeverteilung und somit Kühlung möglich ist. Überdies gestattet der Einsatz eines Stanzgitters eine variable Bestückung zur Ausbildung unterschiedlicher Anschlußeinheiten. Überdies braucht ein in einem Vergußkörper enthaltenes Stanzgitter nicht zusätzlich durch eine Anschlußdose eingeschlossen zu werden, die - wie beim vorbekannten Stand der Technik - eine Wärmeabfuhr verhindert und einen Wärmestau innerhalb der Anschlußdose begünstigt. Zudem existieren bei der beschriebenen Anschlußeinheit und entsprechend bei der beschriebenen Anordnung weniger elektrische Übergänge.

Die beschriebene Ausgestaltung ist sehr flach bauend, was ebenfalls erwünscht ist. Auf der Oberseite des Vergußkörpers können zusätzliche Kabelhalter angeordnet sein, in denen die Anschlußkabel 3, 4, die endseitig mit jeweils einem Steckverbindungsteil bestückt sind, zunächst gehalten sind. Dies ist vorteilhaft, um bei einer Prüfung der aus der Anschlußeinheit 1 und dem Solarstrommodul 7 gebildeten Anordnung einen elektrischen Anschluß zu erleichtern. Ein solcher Kabelhalter kann über eine Sollbruchstelle an den Vergußkörper angeschlossen sein, damit dieser nach einer Montage der Anordnung, beispielsweise auf einem Gebäudedach, entfernbar ist.

Eine Vorrichtung zum Bestücken eines Solarstrommoduls 7 mit einer Anschlußeinheit 1 umfaßt einen Halter zum Halten des Solarstrommoduls 7. Beweglich gegenüber dem fixierten Solarstrommodul 7 ist eine Positioniereinrichtung vorgesehen, mit dem die Anschlußeinheit 1 gegenüber dem Solarstrommodul 7 positionierbar und in ihre bestimmungsgemäße Lage verfahrbar ist. Eine Positionierung der Anschlußeinheit 1 kann beispielsweise auf optischem Wege erfolgen. In einem solchen Fall kann im Bereich der freiliegenden Anschlußleiter A_{S} des Solarstrommoduls 7 eine Zielmarkierung angeordnet sein. Vor einem tatsächlichen Positionieren der Anschlußeinheit 1 auf der Rückseite des Solarstrommoduls 7 sind an den Stellen einer mechanischen Kontaktierung der Rückseite des Solarstrommoduls 7 mit den Klebedomen 9 der Anschlußeinheit 1 Klebepunkte und zur einschließenden Verbindung der Klebering 10 aufgebracht. Die Vorrichtung umfaßt ferner eine Einrichtung zum Ergreifen, Anheben und Aufbiegen der Anschlußabschnitte A_{S} des Solarstrommoduls 7. Zweckmäßigerweise erfolgt dieses durch zwei nacheinander folgende Arbeitsgänge, wobei in einem ersten Aufbiegeschritt die Anschlußabschnitte A_{S} des Solarstrommoduls 7 durch Sauggreifer von der Trennfolie 12 so weit angehoben werden, daß diese von der Oberfläche der Trennfolie 12 abgehoben bleiben. In einem nächsten Schritt erfolgt das eigentliche Heranbiegen der Anschlußabschnitte A_{S} an die bereits abgewinkelten Anschlußabschnitte A_{A} der Anschlußeinheit 1. Die Vorrichtung umfaßt zu diesem Zweck eine der Anzahl der aufzubiegenden Anschlußabschnitte A_{S} entsprechender Anzahl an Sauggreifern. Das Heranbiegen an die Anschlußabschnitte A_{A} der Anschlußeinheit kann beispielsweise durch ein Spreizwerkzeug erfolgen, welches zwischen die gegenüberliegenden Anschlußabschnitte A_{S} eingebracht wird und mit dem sämtliche Anschlußleiter A_{S} gleichzeitig gebogen werden. Die Vorrichtung umfaßt ferner einen gegabelten Niederhalter, mit dem die in der Ebene des Solarstrommoduls 7 verbleibenden und an die Anschlußabschnitte A_{S} grenzenden Flachbandleiterabschnitte von einem Abheben von der Rückseite des Solar strommoduls 7 gehindert werden. Die Vorrichtung umfaßt ferner einen Schweißroboter zum Erstellen der gewünschten Fügeverbindungen zwischen jeweils zwei Anschlußabschnitten A_{A} und A_{S}.

Entsprechend einer weiteren Ausgestaltung ist vorgesehen, daß das Stanzgitter der Anschlußeinheit mit seinen Anschlußabschnitten zunächst mit den Anschlußabschnitten der Leiterbahnstruktur des Moduls verbunden wird und daß anschließend das Stanzgitter insgesamt auf der Rückseite des Moduls durch eine Vergußmasse gekapselt wird. Bei einer solchen Ausgestaltung erfolgt ein Kapseln und ein Verbinden der Anschlußeinheit mit dem Modul in einem einzigen Arbeitsgang, wobei ebenfalls die zwischen dem Modul und der Anschlußeinheit erstellten elektrischen Verbindungen mit verkapselt werden.

### Bezugszeichenliste

- 1: Anschlußeinheit
- 2: Stanzgitter
- 3: Anschlußkabel
- 4: Anschlußkabel
- 5: Vergußkörper
- 6: Vergußkragen
- 7: Solarstrommodul
- 8: Fenster
- 9: Klebedom
- 10: Klebering
- 11: Klebeschicht
- 12: Trennfolie

- A_{A}: Anschlußabschnitt
- A_{S}: Anschlußabschnitt
- B: Brücke
- D: Schutzdioden

## Patentansprüche

1. Anordnung umfassend ein paneelartig aufgebautes elektrisches/elektronisches Modul (7) mit einer flachen Oberfläche mit freiliegend kontaktierbaren Anschlußabschnitten (A_{S}) als Teil einer im wesentlichen ebenen Leiterbahnstruktur zum elektrischen Anschließen des Moduls (7) sowie umfassend eine Anschlußeinheit (1) mit auf einer in einer Ebene parallel zur Leiterbahnstruktur des Moduls (7) angeordneten Leiterbahnstruktur (2) befindlichen elektrischen/elektronischen Elementen (D) sowie ausgestattet mit Mitteln zum Kontaktieren von Anschlußabschnitten des Moduls, so daß das Modul über die Anschlußeinheit elektrisch anschließbar ist, **dadurch gekennzeichnet, daß** die Mittel zum Kontaktieren der Anschlußabschnitte (A_{S}) des Moduls (7) aus der Ebene der Leiterbahnstruktur (2) herausgebogene und einen Teil der Leiterbahnstruktur darstellende Anschlußabschnitte (A_{A}) und die Anschlußabschnitte (A_{S}) des Moduls(7) starre und aus der Ebene der Leiterbahnstruktur des Moduls (7) herausbiegbare elektrische Leiterabschnitte (A_{S}) sind, wobei die Anschlußabschnitte (A_{A}) der Anschlußeinheit (1) entsprechend der Anordnung der Anschlußabschnitte (A_{S}) des Moduls (7) angeordnet sind, so daß bei der mit dem Modul (7) verbundenen Anschlußeinheit (1) jeweils ein Anschlußabschnitt (A_{S}) des Moduls (7) und einer der Anschlußeinheit (1) elektrisch miteinander verbunden in einem Abschnitt aneinandergrenzen und im Bereich des Aneinandergrenzens in einer anderen Raumlage als diejenige der Ebenen der Leiterbahnstrukturen (2) angeordnet sind.

2. Anordnung nach Anspruch 1, **dadurch gekennzeichnet, daß** die Anschlußabschnitte (A_{S}) des Moduls (7) Flachbandleiter sind.

3. Anordnung nach Anspruch 1 oder 2, **dadurch gekennzeichnet, daß** die Anschlußabschnitte (A_{S}) des Moduls (7) in einem Fenster einer isolierenden Abdeckung des Moduls (7) angeordnet sind.

4. Anordnung nach einem der Ansprüche 1 bis 3, **dadurch gekennzeichnet, daß** die Leiterbahnstruktur der Anschlußeinheit (1) ein Stanzgitter (2) ist und die zum Kontaktieren der Anschlußabschnitte (A_{S}) des Moduls (7) vorgesehenen Anschlußabschnitte (A_{A}) der Leiterbahnstruktur (2) der Anschlußeinheit (1) Teil des Stanzgitters (2) sind, auf welchem Stanzgitter (2) die elektrischen/elektronischen Komponenten, etwa Dioden (D), und zumindest ein Anschlußkabel (3, 4) jeweils durch eine Fügeverbindung mit dem Stanzgitter (2) verbunden angeordnet sind.

5. Anordnung nach Anspruch 1 oder 4, **dadurch gekennzeichnet, daß** die Leiterbahnstruktur (2) der Anschlußeinheit (1) mit ihren Elementen (D) mit Ausnahme der Anschlußabschnitte (A_{A}) in einem etwa im Wege eines Spritzgußverfahrens erstellten Vergußkörper (5) eingeschlossen angeordnet ist.

6. Anordnung nach Anspruch 5, **dadurch gekennzeichnet, daß** die zum Kontaktieren der Anschlußabschnitte (A_{S}) der Leiterbahnstruktur des Moduls (7) vorgesehenen Anschlußabschnitte (A_{A}) der Anschlußeinheit (1) in ein Fenster (8) in dem Vergußkörper (5) hineinragend angeordnet sind.

7. Anordnung nach Anspruch 5 oder 6, **dadurch gekennzeichnet, daß** die äußere Oberfläche des Vergußkörper oberflächenvergrößernde Elemente aufweist.

8. Anordnung nach einem der Ansprüche 1 bis 7, **dadurch gekennzeichnet, daß** das Modul der Anordnung ein Solarstrommodul (7) ist.

9. Anschlußeinheit für ein paneelartig aufgebautes elektrisches/elektronisches Modul (7) Ausbilden einer Anordnung nach einem der Ansprüche 1 bis 8, **dadurch gekennzeichnet, daß** die Leiterbahnstruktur der Anschlußeinheit (1) ein Stanzgitter (2) ist und die zum Kontaktieren der Anschlußabschnitte (A_{S}) des Moduls (7) vorgesehenen Anschlußabschnitte (A_{A}) der Leiterbahnstruktur der Anschlußeinheit (1) Teil des Stanzgitters (2) sind, auf welchem Stanzgitter (2) die elektrischen/elektronischen Komponenten, etwa Dioden (D), und zumindest ein Anschlußkabel (4, 5) durch eine Fügeverbindung mit dem Stanzgitter (2) verbunden angeordnet sind.

10. Anschlußeinheit nach Anspruch 9, **dadurch gekennzeichnet, daß** die Anschlußabschnitte (A_{A}) der Anschlußeinheit 1 aus der Ebene des Stanzgitters (2) herausgebogen sind.

11. Anschlußeinheit nach Anspruch 9 oder 10, **dadurch gekennzeichnet, daß** das Stanzgitter (2) mit seinen Elementen (D) mit Ausnahme der Anschlußabschnitte (A_{A}) in einem etwa im Wege eines Spritzgußverfahrens erstellten Vergußkörper (6) eingeschlossen angeordnet ist.

12. Anschlußeinheit nach Anspruch 11, **dadurch gekennzeichnet, daß** die zum Kontaktieren der Anschlußabschnitte (A_{S}) der Leiterbahnstruktur des Moduls (7) vorgesehenen Anschlußabschnitte (A_{A}) der Anschlußeinheit (1) in ein Fenster (8) in dem Vergußkörper (5) hineinragend angeordnet sind.

13. Anschlußeinheit nach Anspruch 11 oder 12, **dadurch gekennzeichnet, daß** die äußere Oberfläche des Vergußkörpers oberflächenvergrößernde Elemente aufweist.

14. Verfahren zum Verbinden einer Anschlußeinheit (1) mit einem paneelartig aufgebauten Modul (7) zum Erstellen einer Anordnung nach einem der Ansprüche 1 bis 8 umfassend die folgenden Schritte:
- Positionieren der Anschlußeinheit (1) mit seinen zum Kontaktieren der Anschlußabschnitte (A_{S}) des Moduls (7) vorgesehenen Anschlußabschnitten (A_{A}) in eine benachbarte über- oder nebeneinanderliegende Anordnung mit den Anschlußabschnitten (A_{S}) des elektrischen/elektronischen Moduls (7), wobei jeweils ein Anschlußabschnitt (A_{A}) der Anschlußeinheit (1) mit einem Anschlußabschnitt (A_{S}) des Moduls (7) eine Verbindungseinheit bildet, liegend
- Ergreifen der Anschlußabschnitte (A_{S}) des Moduls (7),
- Abheben der Anschlußabschnitte (A_{S}) von der Oberfläche des Moduls (7),
- Zusammenführen der Anschlußabschnitte (A_{S}) mit den Anschlußabschnitten (A_{A}) der Anschlußeinheit (1), so daß anschließend die Verbindungseinheiten in einer anderen Raumlage angeordnet sind und die ursprünglich unten liegende und nicht zugängliche Oberfläche der Anschlußabschnitte (A_{S}) zum Durchführen einer Fügeverbindung zum Verbinden jeweils eines Anschlußabschnittes (A_{S}) des Moduls (7) mit einem Anschlußabschnitt (A_{A}) der Anschlußeinheit (1) frei zugänglich ist, und
- Verbinden der Anschlußabschnitte (A_{A}, A_{S}) jeweils einer Verbindungseinheit durch eine Fügeverbindung.

15. Verfahren nach Anspruch 14, **dadurch gekennzeichnet, daß** der Schritt des Ergreifens der Anschlußabschnitte (A_{S}) des Moduls (7) mit Sauggreifern erfolgt.

16. Verfahren nach Anspruch 14 oder 15, **dadurch gekennzeichnet, daß** der Schritt des Positionierens der Anschlußeinheit (1) auf dem Modul (7) ein Verbinden der Anschlußeinheit (1) mit dem Modul (7) beinhaltet, so daß für die nachfolgenden Verfahrensschritte die Anschlußeinheit (1) und das Modul (7) eine gegenständliche Einheit bilden.

17. Verfahren nach Anspruch 16, **dadurch gekennzeichnet, daß** das Verbinden der Anschlußeinheit (1) mit dem Modul (7) über eine zweistufige Klebeverbindung erfolgt, bei der durch die erste Klebestufe eine rasche und zum Durchführen der nachfolgenden Verfahrensschritte ausreichend stabile Fixierung bereitgestellt ist, während eine weitere Klebestufe langsamer aushärtet und eine über die Lebenszeit der mit dem Verfahren hergestellten Anordnung bestimmungsgemäße Verbindung zwischen der Anschlußeinheit (1) und dem Modul (7) gewährleistet.

18. Vorrichtung zum Verbinden einer Anschlußeinheit (1) mit einem paneelartig aufgebauten Modul (7) zum Herstellen einer Anordnung nach einem der Ansprüche 1 bis 8, **dadurch gekennzeichnet, daß** die Vorrichtung einer Halteeinheit zum Fixieren des Moduls (7) für die Dauer des Verbindungsprozesses, eine verfahrbare Positioniereinrichtung zum Positionieren der Anschlußeinheit (1) gegenüber dem Modul (7). Mittel zum Ergreifen der Anschlußabschnitte (A_{S}) des Moduls (7) und Mittel zum Biegen der von der Oberfläche des Moduls (7) abgehobenen Anschlußabschnitte (A_{S}) zum Zusammenführen dieser Anschlußabschnitte (A_{S}) mit den Anschlußabschnitten (A_{A}) der Anschlußeinheit (1) sowie eine Niederhalteranordnung umfaßt, mit der die in ihrer ursprünglichen Lage der Leiterbahnstruktur verbleibenden Abschnitte des Moduls (7) niedergehalten werden, und die Vorrichtung ferner eine Schweißeinrichtung aufweist, mit der die zusammengeführten Anschlußabschnitte (A_{A}, A_{S}) jeweils eine Verbindungseinheit bildend, miteinander verschweißt werden können.

19. Vorrichtung nach Anspruch 18, **dadurch gekennzeichnet, daß** die Vorrichtung ferner zumindest eine Kleberspendeeinrichtung umfaßt, mit der an vorbestimmten Positionen, mit dem die Anschlußeinheit (1) an dem Modul (7) zu befestigen ist, auf der Rückseite des Moduls (7) Kleber ausgebbar ist.

20. Vorrichtung nach Anspruch 18 oder 19, **dadurch gekennzeichnet, daß** die Mittel zum Ergreifen der Anschlußabschnitte (A_{S}) des Moduls (7) Sauggreifer sind.

21. Vorrichtung nach einem der Ansprüche 18 bis 20, **dadurch gekennzeichnet, daß** die Mittel zum Zusammenführen der Anschlußabschnitte (A_{S}) mit denjenigen der Anschlußeinheit (1) Spreizmittel sind.

## Claims

1. Arrangement comprising a panel-like electrical/electronic module (7) having a flat surface with openly contactable connecting sections (A_{S}) as part of an essentially flat printed conductor structure for the electrical connection of the module (7), and comprising a connection unit (1) having electrical/electronic elements (D) located on a printed conductor structure (2), which is arranged in a plane parallel to the printed conductor structure of the module (7), and equipped with means for contacting connecting sections of the module, such that the module can be electrically connected via the connection unit, **characterised in that** the means for contacting the connecting sections (A_{S}) of the module (7) are bent out of the plane of the printed conductor structure (2) and some of the connecting sections (A_{A}) representing the printed conductor structure and the connecting sections (Aₛ) of the module (7) are rigid electrical conductor sections (A_{S}) which can be bent out of the plane of the printed conductor structure of the module (7), the connecting sections (A_{A}) of the connection unit (1) being arranged corresponding to the arrangement of the connecting sections (A_{S}) of the module (7), such that when the connection unit (1) is joined to the module (7), each connecting section (A_{S}) of the module (7) is electrically connected to a connecting section of the connection unit (1), and they adjoin one another in one section and, in the region where they adjoin, are arranged in a different spatial position from that of the planes of the printed conductor structures (2).

2. Arrangement according to claim 1, **characterised in that** the connecting sections (A_{S}) of the module (7) are ribbon conductors.

3. Arrangement according to claim 1 or 2, **characterised in that** the connecting sections (A_{S}) of the module (7) are arranged in a window of an insulating covering of the module (7).

4. Arrangement according to one of claims 1 to 3, **characterised in that** the printed conductor structure of the connection unit (1) is a stamped grid (2) and the connecting sections (A_{A}) of the printed conductor structure (2) of the connection unit (1), which are provided for contacting the connecting sections (A_{S}) of the module (7), are part of the stamped grid (2) on which the electrical/electronic components, such as diodes (D), and at least one connecting cable (3, 4) are arranged, in each case connected to the stamped grid (2) by a jointed connection.

5. Arrangement according to claim 1 or 4, **characterised in that** the printed conductor structure (2) of the connection unit (1) is arranged enclosed with its elements (D), apart from the connecting sections (A_{A}), in a casting body (5) which may be produced by an injection-moulding process.

6. Arrangement according to claim 5, **characterised in that** the connecting sections (A_{A}) of the connection unit (1), which are provided for contacting the connecting sections (A_{S}) of the printed conductor structure (2) of the module (7), are arranged protruding into a window (8) in the casting body (5).

7. Arrangement according to claim 5 or 6, **characterised in that** the outer surface of the casting body has surface-enlarging elements.

8. Arrangement according to one of claims 1 to 7, **characterised in that** the module of the arrangement is a solar power module (7).

9. Connection unit for a panel-like electrical/electronic module (7) for forming an arrangement according to one of claims 1 to 8, **characterised in that** the printed conductor structure of the connection unit (1) is a stamped grid (2) and the connecting sections (A_{A}) of the printed conductor structure (2) of the connection unit (1), which are provided for contacting the connecting sections (A_{S}) of the module (7), are part of the stamped grid (2) on which the electrical/electronic components, such as diodes (D), and at least one connecting cable (4, 5) are arranged, connected to the stamped grid (2) by a jointed connection.

10. Connection unit according to claim 9, **characterised in that** the connecting sections (A_{A}) of the connection unit (1) are bent out of the plane of the stamped grid (2).

11. Connection unit according to claim 9 or 10, **characterised in that** the stamped grid (2) is arranged enclosed with its elements (D), apart from the connecting sections (A_{A}), in a casting body (6) which may be produced by an injection-moulding process.

12. Connection unit according to claim 11, **characterised in that** the connecting sections (A_{A}) of the connection unit (1), which are provided for contacting the connecting sections (A_{S}) of the printed conductor structure of the module (7), are arranged protruding into a window (8) in the casting body (5).

13. Connection unit according to claim 11 or 12, **characterised in that** the outer surface of the casting body has surface-enlarging elements.

14. Method for connecting a connection unit (1) to a panel-like module (7) to produce an arrangement according to one of claims 1 to 8, comprising the following steps:
- positioning the connection unit (1) with its connecting sections (A_{A}), which are provided for contacting the connecting sections (A_{S}) of the module (7), in an adjoining superposed or adjacent arrangement with the connecting sections (A_{S}) of the electrical/electronic module (7), each connecting section (A_{A}) of the connection unit (1) forming a joined unit with a connecting section (A_{S}) of the module (7),
- grasping the connecting sections (A_{S}) of the module (7),
- lifting the connecting sections (A_{S}) from the surface of the module (7),
- bringing the connecting sections (A_{S}) together with the connecting sections (A_{A}) of the connection unit (1) such that the joined units are then arranged in a different spatial position, and the surface of the connecting sections (A_{S}), which was originally located underneath and inaccessible, is freely accessible for producing a jointed connection to join each connecting section (A_{S}) of the module (7) to a connecting section (A_{A}) of the connection unit (1), and
- joining the connecting sections (A_{A}, A_{S}) of each joined unit by means of a jointed connection.

15. Method according to claim 14, **characterised in that** the step of grasping the connecting sections (A_{S}) of the module (7) is carried out using vacuum grippers.

16. Method according to claim 14 or 15, **characterised in that** the step of positioning the connection unit (1) on the module (7) includes joining the connection unit (1) to the module, such that the connection unit (1) and the module (7) form a concrete unit for the subsequent method steps.

17. Method according to claim 16, **characterised in that** the connection unit (1) is joined to the module (7) by means of a two-step adhesive connection, in which a rapid fixing, which is sufficiently stable for carrying out the subsequent method steps, is provided by the first gluing step, whilst a further gluing step cures more slowly and guarantees a proper connection between the connection unit (1) and the module (7) over the service life of the arrangement produced by the method.

18. Device for joining a connection unit (1) to a panel-like module (7) to produce an arrangement according to one of claims 1 to 8, **characterised in that** the device comprises:
- a holding unit for fixing the module (7) for the duration of the joining process,
- a moveable positioning device for positioning the connection unit (1) relative to the module (7),
- means for grasping the connecting sections (A_{S}) of the module (7) and
- means for bending the connecting sections (A_{S}), which are lifted from the surface of the module (7), to bring these connecting sections (A_{S}) together with the connecting sections (A_{A}) of the connection unit (1), as well as
- a holding-down arrangement with which the sections of the module (7) which remain in their original position on the printed conductor structure are held down,
- and the device also has a welding device by means of which the connecting sections (A_{A},A_{S}), brought together to form respective joined units, may be welded to each other.

19. Device according to claim 18, **characterised in that** the device also comprises at least one adhesive dispenser, by means of which adhesive may be dispensed at predetermined positions on the rear side of the module (7) for fastening the connection unit (1) to the module (7).

20. Device according to claim 18 or 19, **characterised in that** the means for grasping the connecting sections (A_{S}) of the module (7) are vacuum grippers.

21. Device according to one of claims 18 to 20, **characterised in that** the means for bringing the connecting sections (A_{S}) together with those of the connection unit (1) are spreading means.

## Revendications

1. Système comprenant un module électrique/électronique (7) construit à la manière d'un panneau, comprenant une surface plane avec des sections de raccordement (A_{S}) exposées pour un contact éventuel, lesquelles font partie d'une structure de circuits imprimés sensiblement plane destinée au raccordement électrique du module (7) et comprenant également une unité de raccordement (1) avec des éléments électriques/électroniques (D) situés sur une structure de circuits imprimés (2) disposée dans un plan parallèle à la structure de circuits imprimés du module (7) et équipée également de moyens pour établir un contact avec les sections de raccordement du module, de sorte que le module puisse être raccordé électriquement par le biais de l'unité de raccordement **caractérisé en ce que** les moyens pour établir un contact avec les sections de raccordement (A_{S}) du module (7) sont des sections de raccordement (A_{A}) extraites par recourbement du plan de la structure de circuits imprimés (2) et faisant partie des sections de raccordement (A_{A}) de la structure de circuits imprimés et que les sections de raccordement (A_{S}) du module (7) sont des sections conductrices (A_{S}) électriques rigides, qui peuvent être extraites par recourbement du plan de la structure de circuits imprimés du module, les sections de raccordement (A_{A}) de l'unité de raccordement (1) étant disposées pour correspondre à la disposition des sections de raccordement (A_{S}) du module (7) de sorte que, pour l'unité de raccordement (1) raccordée au module (7), une section de raccordement (A_{S}) du module (7) et une section de raccordement de l'unité de raccordement (1) sont raccordées électriquement, contiguës au niveau d'une section, et sont disposées dans la zone de contiguïté dans une autre position spatiale que celle des plans des structures de circuits imprimés (2).

2. Système selon la revendication 1 **caractérisé en ce que** les sections de raccordement (A_{S}) du module (7) sont des conducteurs rubans.

3. Système selon la revendication 1 ou 2 **caractérisé en ce que** les sections de raccordement (A_{S}) du module (7) sont disposées dans une fenêtre d'un habillage isolant du module (7).

4. Système selon l'une des revendications 1 à 3 **caractérisé en ce que** la structure de circuits imprimés de l'unité de raccordement (1) est une grille de connexion (2) et que les sections de raccordement (A_{A}) de la structure de circuits imprimés (2) de l'unité de raccordement (1), lesquelles sont prévues pour établir un contact avec les sections de raccordement (A_{S}) du module (7), font partie de la grille de connexion (2) sur laquelle grille de connexion (2), les composants électriques/électroniques, par exemple les diodes (D), et au moins un câble de raccordement (3, 4) sont disposés et à laquelle grille de connexion (2) ils sont reliés par jonction.

5. Système selon la revendication 1 ou 4 **caractérisé en ce que** la structure de circuits imprimés (2) de l'unité de raccordement (1) avec ses éléments (D), à l'exception des sections de raccordement (A_{A}), est scellée dans un enrobage (5) réalisé par exemple lors d'un procédé de moulage par injection.

6. Système selon la revendication 5 **caractérisé en ce que** les sections de raccordement (A_{A}) de l'unité de raccordement (1) prévues pour établir un contact avec les sections de raccordement (A_{S}) de la structure de circuits imprimés du module (7) sont disposées pour s'engager dans une fenêtre (8) de l'enrobage (5).

7. Système selon la revendication 5 ou 6 **caractérisé en ce que** la surface extérieure de l'enrobage présente des éléments agrandissant la surface.

8. Système selon l'une des revendications 1 à 7 **caractérisé en ce que** le module du système est un module solaire (7).

9. Unité de raccordement pour un module (7) électrique/électronique construit à la manière d'un panneau pour former un système selon l'une des revendications 1 à 8 **caractérisée en ce que** la structure de circuits imprimés de l'unité de raccordement (1) est une grille de connexion (2) et que les sections de raccordement (A_{A}) de la structure de circuits imprimés de l'unité de raccordement (1), qui sont prévue pour établir le contact avec les sections de raccordement (A_{S}) du module (7), font partie de la grille de connexion (2), sur laquelle grille de connexion (2) sont également placés et reliés par jonction à la grille de connexion (2) les composants électriques/électroniques, par exemple des diodes (D), et au moins un câble de raccordement (3, 4).

10. Unité de raccordement selon la revendication 9 **caractérisée en ce que** les sections de raccordement (A_{A}) de l'unité de raccordement 1 sont extraites par recourbement du plan de la grille de connexion (2).

11. Unité de raccordement selon la revendication 9 ou 10 **caractérisée en ce que** la grille de connexion (2) avec ses éléments (D), à l'exception des sections de raccordement (A_{A}), est scellée dans un enrobage (5) réalisé par exemple lors d'un procédé de moulage par injection.

12. Unité de raccordement selon la revendication 11 **caractérisée en ce que** les sections de raccordement (A_{A}) de l'unité de raccordement (1) prévues pour établir un contact avec les sections de raccordement (A_{S}) de la structure de circuits imprimés du module (7) sont disposées pour s'engager dans une fenêtre (8) de l'enrobage (5).

13. Unité de raccordement selon la revendication 11 ou 12 **caractérisée en ce que** la surface extérieure de l'enrobage présente des éléments agrandissant la surface.

14. Procédé pour associer une unité de raccordement (1) avec un module (7) construit à la manière d'un panneau afin de réaliser le système selon l'une des revendications 1 à 8 comprenant les étapes suivantes :
- positionnement de l'unité de raccordement (1) avec ses sections de raccordement (A_{A}) prévues pour établir un contact avec les sections de raccordement (A_{S}) du module (7) dans une disposition contiguë, superposée ou côte à côte, avec les sections de raccordement (A_{S}) du module (7) électrique/électronique, une section de raccordement (A_{A}) de l'unité de raccordement (1) formant avec une section de raccordement (A_{S}) du module (7) une unité jointée, couchée
- saisie des sections de raccordement (A_{S}) du module (7),
- soulèvement des sections de raccordement (A_{S}) de la surface du module (7),
- rassemblement des sections de raccordement (A_{S}) avec les sections de raccordement (A_{A}) de l'unité de raccordement (1), de sorte que les unités jointées soient ensuite placées dans une autre position spatiale et que la surface des sections de raccordement (A_{S}) orientée initialement vers le bas et non accessibles soit librement accessible afin de réaliser une jonction pour relier une section de raccordement (A_{S}) du module (7) avec une section de raccordement (A_{A}) de l'unité de raccordement (1), et
- association des sections de raccordement (A_{A}, A_{S}) d'une unité jointée par une jonction.

15. Procédé selon la revendication 14 **caractérisé en ce que** l'étape de saisie des sections de raccordement (A_{S}) du module (7) s'effectue avec des pinces aspirantes.

16. Procédé selon la revendication 14 ou 15 **caractérisé en ce que** l'étape de positionnement de l'unité de raccordement (1) sur le module (7) inclut une liaison de l'unité de raccordement (1) avec le module (7) de sorte que l'unité de raccordement (1) et le module (7) forment, pour les étapes suivantes du procédé, une unité d'objet.

17. Procédé selon la revendication 16 **caractérisé en ce que** la liaison de l'unité de raccordement (1) avec le module (7) se fait par une liaison collée en deux étapes, pour laquelle une première étape de collage met à disposition une fixation rapide et suffisamment stable pour réaliser l'étape suivante du procédé, tandis que l'étape de collage suivante connaît un durcissement plus lent et garantit une liaison entre l'unité de raccordement (1) et le module (7) qui correspond à la durée de vie du système fabriqué avec le procédé.

18. Dispositif pour relier une unité de raccordement (1) avec un module (7) construit à la manière d'un panneau pour fabriquer un système selon l'une des revendications 1 à 8 **caractérisé en ce que** le dispositif comprend une unité de maintien pour fixer le module (7) pendant la durée du processus de liaison, un équipement de positionnement mobile servant à positionner l'unité de raccordement (1) par rapport au module (7), des moyens pour saisir les sections de raccordement (A_{S}) du module (7) et des moyens pour recourber les sections de raccordement (A_{S}) soulevés de la surface du module (7) afin de rassembler ces sections de raccordement (A_{S}) avec les sections de raccordement (A_{A}) de l'unité de raccordement (1) ainsi qu'une disposition d'éléments de retenue avec laquelle les sections du module (7) devant rester dans leur position initiale dans la structure de circuits imprimés sont retenues et le dispositif comprenant par ailleurs une unité de soudage avec laquelle des sections de raccordement (A_{A}, A_{S}) rassemblées et formant une unité jointée, peuvent être soudées l'une à l'autre.

19. Dispositif selon la revendication 18 **caractérisé en ce que** le dispositif comprenne par ailleurs au moins un applicateur de colle qui permet d'apposer de la colle au dos du module (7), aux positions déterminées, là où l'unité de raccordement (1) doit être fixée au module (7).

20. Dispositif selon la revendication 18 ou 19 **caractérisé en ce** les moyens pour saisir les sections de raccordement (A_{S}) du module (7) sont des pinces aspirantes.

21. Dispositif selon l'une des revendications 18 à 20 **caractérisé en ce que** les moyens pour rassembler les sections de raccordement (A_{S}) à celles de l'unité de raccordement (1) sont des moyens d'écartement.
